# EUROPEAN PATENT APPLICATION

(11) **EP 4 560 839 A1**
(43) Date of publication of application: **28.05.2025**
(21) Application number: 22951924.4
(22) Date of filing: 19.07.2022
(51) Int. Cl.: H01R 11/01

(54) **ANISOTROPICALLY CONDUCTIVE CONNECTOR, ANISOTROPICALLY CONDUCTIVE CONNECTOR HAVING FRAME, AND INSPECTION APPARATUS**

(71) Applicant: Shin-Etsu Polymer Co., Ltd., Tokyo 100-0004 (JP)
(72) Inventor: SASAKI Yuichiro, Shiojiri-shi, Nagano 399-0705 (JP)
(74) Representative: TBK
(86) International application number: PCT/JP2022/028084
(87) International publication number: WO 2024/018535

(57) **Abstract**

The object of the present invention is to provide an anisotropically conductive connector that can be arranged at narrow pitches to match the compactness of electric and electronic components, has excellent connection stability to an electrode, does not easily damage the electrode to be connected, can reduce the accumulation of oxidized foreign matter and suppress an increase in resistance value, and is easy to replace even if conduction failure occurs during use, an anisotropically conductive connector having a frame, and an inspection apparatus. An anisotropically conductive connector including an insulation portion which is strip-shaped and made of an elastic material having insulating properties, and a plurality of silver wires which penetrate the insulation portion from a first surface to a second surface in a thickness direction and are arranged at a constant pitch in a length direction of the insulation portion, wherein each of the plurality of silver wires is provided perpendicularly or obliquely to the thickness direction of the insulation portion.

## Description

### TECHNICAL FIELD

The present invention relates to an anisotropically conductive connector, an anisotropically conductive connector having a frame and an inspection apparatus.

### BACKGROUND ART

For electrical inspection of electronic device parts and module parts, as well as semiconductor devices such as BGA (Ball Grid Array), QFN (Quad Flat No Lead), SOP (Small Outline Package), QFP (Quad Flat Package), and CSP (Chip Size Package), sockets and the like which include a probe pin (pogo pin) are used as an inspection apparatus (Patent Document 1).

Further, as a conductive connector that connects between a liquid crystal panel and a circuit board, a conductive connector with silver wires is known (Patent Document 2).

### PRIOR ART DOCUMENTS

### PATENT DOCUMENTS

Patent Document 1 Japanese Unexamined Patent Application, First Publication No. 2019-125421
Patent Document 2 Japanese Unexamined Utility Model Application, First Publication No. Sho 61-184283

### SUMMARY OF INVENTION

### PROBLEM TO BE SOLVED BY THE INVENTION

In recent years, as electric and electronic components have been reduced in size, the outer dimensions of electronic device components and module components, as well as the electrode size (width x length) and pitch, have become downsized. For this reason, it has become difficult to arrange probe pins in an inspection apparatus that corresponds to downsizing.

Furthermore, the solder ball electrodes of BGA, CSP, and the flat electrodes of QFN, and the like have their surfaces plated with tin. It is known that an oxide film is formed on the surface layer of the electrode over time, increasing the resistance value. Therefore, in testing such semiconductor devices, a probe pin having a crown-shaped tip is used, and the tip is pressed against the electrode to be inspected so as to pierce it, thereby breaking the oxide film and ensuring conduction. However, in this testing method, oxidized foreign matter such as solder debris and tin plating debris generated from the electrodes may accumulate on the tip of the probe pin, increasing the resistance value.

Furthermore, in an inspection apparatus including probe pins, a plurality of probe pins are generally held in a resin holder. However, when a conduction failure occurs only in a specific probe pin, it is difficult to replace only the probe pin in which the conduction failure has occurred. Further, since probe pins are expensive, replacing all the probe pins in each holder is a major disadvantage in terms of cost.

The object of the present invention is to provide an anisotropically conductive connector that can be arranged at narrow pitches to match the compactness of electric and electronic components, has excellent connection stability to an electrode, does not easily damage the electrode to be connected, can reduce the accumulation of oxidized foreign matter and suppress an increase in resistance value, and is easy to replace even if conduction failure occurs during use, an anisotropically conductive connector having a frame, and an inspection apparatus.

### MEANS FOR SOLVING THE PROBLEM

The present invention has the following aspects.
[1] An anisotropically conductive connector including an insulation portion which is strip-shaped and made of an elastic material having insulating properties, and a plurality of silver wires which penetrate the insulation portion from a first surface to a second surface in a thickness direction and are arranged at a constant pitch in a length direction of the insulation portion, wherein each of the plurality of silver wires is provided perpendicularly or obliquely to the second surface of the insulation portion.
[2] The anisotropically conductive connector according to [1], wherein a tensile strength of the silver wires measured according to JIS Z 2241 is 200 N/mm² or more and 380 N/mm² or less.
[3] The anisotropically conductive connector according to [1] or [2], wherein a gold plating film is formed on the side surface of the silver wires.
[4] The anisotropically conductive connector according to [1], wherein a compression set of the insulation portion is 20% or less.
[5] An anisotropically conductive connector having a frame, wherein a positioning frame is fixed to at least a part of the periphery of the anisotropically conductive connector according to any one of [1] to [4].
[6] An inspection apparatus for an electric and electronic component, including a circuit board having an electrode terminal, the anisotropically conductive connector according to any one of [1] to [4], and a holder, wherein at least a part of a peripheral portion of the anisotropically conductive connector is fixed onto the circuit board by the holder, wherein the electrode terminal is in contact with one end of the silver wires of the anisotropically conductive connector on the side in contact with the circuit board, wherein during inspection, the electric and electronic component is fitted and pressed to a region of the anisotropically conductive connector opposite to the side in contact with the circuit board, and not in contact with the holder, and an electrode of the electric and electronic component is in contact with the other end of the silver wires of the anisotropically conductive connector on an opposite side to the side in contact with the circuit board.
[7] An inspection apparatus for an electric and electronic component, including a circuit board having an electrode terminal, the anisotropically conductive connector having a frame according to [5], and a holder, wherein at least a part of the frame of the anisotropically conductive connector having a frame is fixed onto the circuit board by the holder; wherein the electrode terminal is in contact with one end of the silver wires of the anisotropically conductive connector having a frame on the side in contact with circuit board, wherein during inspection, the electric and electronic component is fitted and pressed to a region of the anisotropically conductive connector having a frame opposite to the side in contact with the circuit board, and not in contact with the holder, and an electrode of the electric and electronic component is in contact with the other end of the silver wires of the anisotropically conductive connector having a frame on an opposite side to the side in contact with the circuit board.

### EFFECTS OF THE INVENTION

According to the present invention, it is possible to provide an anisotropically conductive connector that can be arranged at narrow pitches to match the compactness of electric and electronic components, has excellent connection stability to an electrode, does not easily damage the electrode to be connected, can reduce the accumulation of oxidized foreign matter and suppress an increase in resistance value, and is easy to replace even if conduction failure occurs during use, an anisotropically conductive connector having a frame, and an inspection apparatus.

### BRIEF DESCRIPTION OF DRAWINGS

[FIG. 1] FIG. 1 is a plan view showing a schematic configuration of an anisotropically conductive connector according to an embodiment of the present invention.
[FIG. 2] FIG. 2 is a cross-sectional view taken along line A-A of the anisotropically conductive connector in FIG. 1.
[FIG. 3] FIG. 3 is a perspective view showing a manufacturing process of the anisotropically conductive connector according to an embodiment of the present invention.
[FIG. 4] FIG. 4 is a perspective view showing another manufacturing process of the anisotropically conductive connector according to an embodiment of the present invention.
[FIG. 5] FIG. 5 is a perspective view showing another manufacturing process of the anisotropically conductive connector according to an embodiment of the present invention.
[FIG. 6] FIG. 6 is a plan view showing a schematic configuration of an anisotropically conductive connector according to another embodiment of the present invention.
[FIG. 7] FIG. 7 is a plan view showing a schematic configuration of an anisotropically conductive connector according to another example of the embodiment.
[FIG. 8] FIG. 8 is a plan view showing a schematic configuration of an anisotropically conductive connector having a frame according to an embodiment of the present invention.
[FIG. 9] FIG. 9 is a perspective view showing a schematic configuration of an inspection apparatus according to an embodiment of the present invention.
[FIG. 10] FIG. 10 is a perspective view showing a schematic configuration of an inspection apparatus according to another embodiment of the present invention.
[FIG. 11] FIG. 11 is a graph showing initial contactability evaluation test results of an anisotropically conductive connector in Experimental Example 1.
[FIG. 12] FIG. 12 is a graph showing initial contactability evaluation test results of an anisotropically conductive connector in Experimental Example 2.
[FIG. 13] FIG. 13 is a graph showing evaluation test results of repeated compression characteristics (durability) of an anisotropically conductive connector in Experimental Example 3.
[FIG. 14] FIG. 14 is a graph showing evaluation test results of repeated compression characteristics (durability) of the anisotropically conductive connector in Experimental Example 4.

### DETAILED DESCRIPTION OF THE PREFERRED EMBODIMENTS

An embodiment of the present invention will be described below based on the drawings.

Note that the dimensions in the figures illustrated in the following description are merely examples, and the present invention is not necessarily limited thereto, and can be realized with appropriate changes within the scope of the gist thereof.

Furthermore, in the present description and claims, the lower and upper limits of the numerical range indicated by "~" are included in the numerical range.

### [Anisotropically conductive connector]

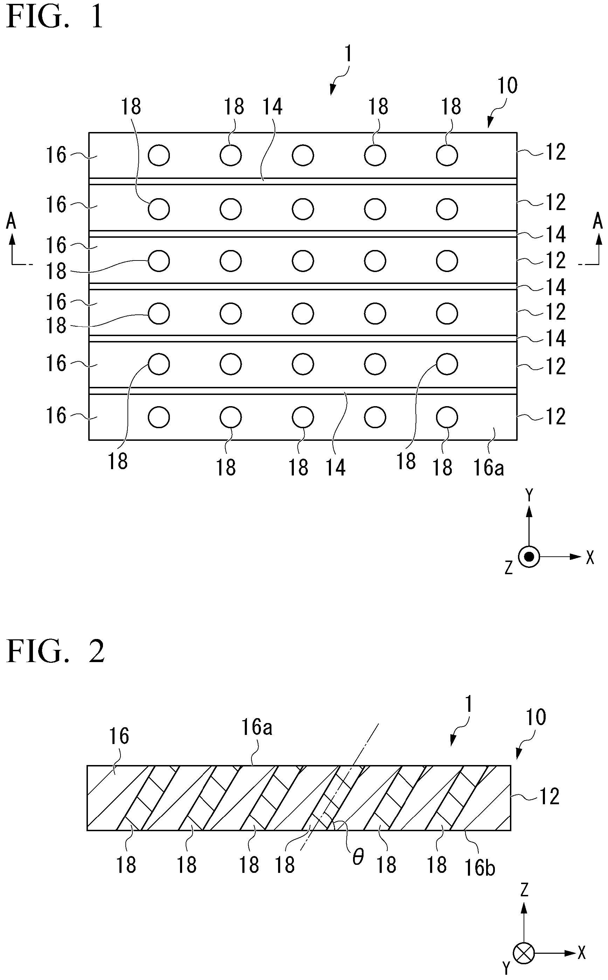

As shown in FIGS. 1 and 2, an anisotropically conductive connector 1 according to the present embodiment includes a sheet-shaped conductive portion 10 including a plurality of rows of conductive band portions 12. In the conductive portion 10, a plurality of rows of the conductive band portions 12 are arranged in parallel, and adjacent conductive band portions 12 are adhered by adhesive portions 14. In the present specification, a direction in which the plurality of rows of conductive band portions 12 extend in parallel is a length direction (X direction in FIGS. 1 and 2), a lamination direction of the plurality of rows of conductive band portions 12 laminated by the adhesive portions 14 is a width direction (Y direction in FIGS. 1 and 2), and the direction perpendicular to both the length direction and the width direction is a thickness direction (Z direction in FIGS. 1 and 2).

The conductive band portion 12 includes a strip-shaped insulation portion 16 which is made of an elastic material with insulation properties and a plurality of silver wires 18 which penetrate through the insulation portion 16 from a first surface 16a to a second surface 16b in the thickness direction (Z direction) and are arranged at a constant pitch in the length direction (X direction) of the insulation portion 16. Note that the silver wires may also be conductive wires made of a silver alloy.

The thickness of the insulation portion 16 may be suitably set depending on the application, and may be, for example, 0.07 mm or more and 2.0 mm or less. The thickness of the insulation portion 16 is the average value of the thickness values measured at ten arbitrarily selected points from the cross section of the insulation portion 16 in the thickness direction using a magnifying observation means such as a measuring microscope.

The length and width of the strip-shaped insulation portion 16 are not particularly limited and can be set as appropriate. The length of the insulation portion 16 can be, for example, 2 mm or more and 50 mm or less. The width of the insulation portion 16 can be, for example, 0.03 mm or more and 0.25 mm or less. The length and width of the insulation portion 16 are average values measured at 10 arbitrarily selected locations.

The material constituting the insulation portion 16 is an insulating elastic material. Examples of the material constituting the insulation portion 16 include elastomers such as urethane rubber, isoprene rubber, ethylene propylene rubber, natural rubber, ethylene propylene diene rubber, styrene butadiene rubber, and silicone rubber. Among these, silicone rubber is preferred because of its low compression set. The silicone rubber may be a condensation type silicone rubber or an addition type silicone rubber. The elastic material constituting the insulation portion 16 may contain additives such as a silane coupling agent, an adhesion aid, an antioxidant, a dye, a pigment, a filler, a leveling agent, and the like.

The compression set of the insulation portion 16 is preferably 20% or less, and more preferably 18% or less. If the compression set of the insulation portion 16 is equal to or less than the upper limit value, it can easily follow compression due to pressure contact of electric and electronic components during inspection, and expansion and contraction caused by changes in environmental conditions such as temperature and humidity. Therefore, a more stable connection can be ensured. Furthermore, the amount of compression in the thickness direction of the anisotropically conductive connector 1 during use can be set over a wide range. The lower limit of the compression set of the insulation portion 16 is not particularly limited, and the smaller the better.

Note that the compression set of the insulation portion 16 is measured according to JIS K 6262 (85°C x 24 hr, 25% compression).

In the conductive band portion 12, the plurality of silver wires 18 are arranged at a constant pitch in the length direction (X direction) of the strip-shaped insulation portion 16. The pitch of the silver wires 18, that is, the center-to-center distance of the silver wires 18 viewed from the first surface 16a side of the insulation portion 16 is not particularly limited, and can be arbitrarily set, for example, according to the impedance simulation results. For example, the pitch of the silver wires 18 can be 5 µm or more and 100 µm or less. The pitch of the silver wires 18 is the average value of the measured distances between the centers of ten arbitrarily selected sets of adjacent silver wires 18.

In the embodiment shown in FIG. 2, the silver wires 18 are provided at an angle with respect to the second surface 16b of the insulation portion 16.

Compared to an anisotropically conductive connector in which the silver wires 18 are perpendicular to the second surface 16b of the insulation portion 16, an anisotropically conductive connector 1 in which the silver wires 18 are inclined with respect to the second surface 16b of the insulation portion 16 has excellent resistance to repeated compression in the thickness direction. Therefore, an anisotropically conductive connector 1 in which the silver wires 18 are inclined is particularly useful for inspecting electric and electronic parts such as electronic device parts and module parts.

Note that the use of the anisotropically conductive connector 1 is not limited to testing electric and electronic components, but also, for example, for mounting on electric and electronic components, such as electrically connecting electrodes between substrates of electronic device components, module components, and the like.

The inclination angle θ of the silver wires 18 with respect to the second surface 16b of the insulation portion 16 is preferably 50 degrees or more, more preferably 55 degrees or more, and even more preferably 60 degrees or more. If the inclination angle θ of the silver wires 18 is greater than or equal to the lower limit value, buckling (plastic deformation) of the silver wires 18 during compression can be easily suppressed. The inclination angle θ of the silver wires 18 is preferably 75 degrees or less, more preferably 70 degrees or less, and even more preferably 65 degrees or less. If the inclination angle θ of the silver wires 18 is less than or equal to the upper limit value, the initial contactability during compression is improved. The preferable lower and upper limits of the inclination angle θ of the silver wires 18 can be arbitrarily combined, and are, for example, preferably 50 ~ 75 degrees, more preferably 55 ~ 70 degrees, and even more preferably 60 ~ 65 degrees. The inclination angle θ of the silver wires 18 is the average value of the inclination angles of ten arbitrarily selected silver wires 18.

Note that the inclination angle θ of the silver wires 18 with respect to the second surface 16b of the insulation portion 16 means an inferior angle (0 < θ < 90) in the angle between the second surface 16b of the insulation portion 16 and the central axis of the silver wires 18.

The silver wires 18 are more flexible than conventional conductive wires such as copper alloy wires and brass wires. By using flexible silver wires 18 as a conductive wire, when inspecting electric and electronic components or mounting them on electric and electronic components, it is possible to connect the silver wires to the electrodes of electric and electronic components with low resistance and low load. As a result, the electrode to be inspected becomes less likely to be damaged and the accumulation of oxidized foreign matter is suppressed to a minimum, so that it is possible to suppress the resistance value from increasing over time. Furthermore, when the anisotropically conductive connector 1 is compressed, the silver wires 18 are less likely to buckle and easily follow the deformation of the insulating portion 16. Therefore, the tip of the silver wires 18 that comes into contact with the electrode is less likely to penetrate the insulating portion 16, and the electrical connection between the electrodes becomes stable. Furthermore, by using the silver wires 18, the silver wires 18 can be easily arranged at narrow pitches in accordance with the shape and pitch of the electrodes even in compact electric and electronic components. Since a plurality of silver wires 18 can be brought into contact with one electrode, connection stability is further improved.

The tensile strength of the silver wires 18 is preferably 200 N/mm² or more, and more preferably 220 N/mm² or more. If the tensile strength of the silver wires 18 is greater than or equal to the lower limit of the above range, the silver wires 18 will be easier to follow the deformation of the surrounding insulating portion 16. Further, the tensile strength of the silver wires 18 is preferably 380 N/mm² or less, and more preferably 360 N/mm² or less. If the tensile strength of the silver wires 18 is less than or equal to the upper limit of the above range, it is difficult for the silver wires 18 to buckle and penetrate the insulating portion 16, resulting in a stable connection. The lower and upper limits of the tensile strength of the silver wires 18 can be arbitrarily combined, and are preferably 200 N/mm² or more and 380 N/mm² or less, for example.

The tensile strength of the silver wires 18 was obtained by carrying out a tensile test with a sample length (distance between the upper and lower chucks) of 100 mm and a tensile speed of 20 mm/min using a tensile testing machine compliant with JIS Z 2241, specifically, a Tensilon universal material testing machine RTI-1225 (manufactured by A&D Co., Ltd.) with a UR-10N-D as a load cell, and calculating by dividing the maximum value of the test force applied to the sample by the cross-sectional area of the sample.

The elongation at break of the silver wires 18 is preferably 0.90% or more, more preferably 1.00% or more, and even more preferably 1.10% or more. Moreover, the elongation at break of the silver wires18 is preferably 1.30% or less, more preferably 1.25% or less, and even more preferably 1.20% or less. If the elongation at break of the silver wires18 is within the lower limit and upper limit, deformation of the silver wires18 during the product cutting process described below can be easily suppressed. The lower and upper limits of the elongation at break of the silver wires18 can be arbitrarily combined, and are, for example, preferably 0.90 ~ 1.30%, more preferably 1.00 ~ 1.25%, and even more preferably 1.10 ~ 1.25%.

The elongation at break is a value measured according to JIS Z 2241.

The maximum point load of the silver wires18 is preferably 0.14 N or more, more preferably 0.15 N or more, and even more preferably 0.16 N or more. Further, the maximum point elongation of the silver wires18 is preferably 0.20 N or less, more preferably 0.18 N or less, and even more preferably 0.17 N or less. If the maximum point elongation of the silver wires18 is within the lower and upper limits, damage to the electrodes of the electric and electronic components to be inspected can be easily suppressed. The preferable lower limit and upper limit of the maximum point load of the silver wires18 can be arbitrarily combined, and are, for example, preferably 0.14 N ~ 0.20 N, more preferably 0.15 N ~ 0.18 N, and even more preferably 0.16 ~ 0.17N.

The maximum point load is a value measured according to JIS Z 2241.

The 0.2% proof load of the silver wires18 is preferably 0.12 N or more, more preferably 0.13 N or more, and even more preferably 0.14 N or more. Further, the 0.2% proof load of the silver wires18 is preferably 0.18 N or less, more preferably 0.17 N or less, and even more preferably 0.16 N or less. The preferable lower and upper limits of the 0.2% proof load of the silver wires 18 can be arbitrarily combined, and are, for example, preferably 0.12 N ~ 0.18 N, more preferably 0.13 N ~ 0.17 N, and even more preferably 0.14 N ~ 0.16 N.

The 0.2% proof load is a value measured according to JIS Z 2241.

The maximum point load and the 0.2% proof load of the silver wires 18 depend on the wire diameter of the silver wires 18. Therefore, by adjusting the wire diameter of the silver wires 18, the maximum point load and the 0.2% proof load of the silver wires 18 can be adjusted.

A coating layer may be formed on the side surface of the silver wires 18. Examples of the material for the coating layer include gold, nickel, and copper. The coating layer may be one layer or two or more layers.

Unlike copper alloy wires such as brass wires and beryllium copper wires, silver wires with one layer of gold plating do not form an oxide film and are stable, and they have excellent adhesion with the insulation portion 16 around the silver wires 18. Therefore, in the experimental examples described below, silver wires coated with one layer of gold plating are used.

The shape of the cross section of the silver wires 18 in the direction orthogonal to the length direction is not particularly limited, and may be, for example, approximately circular, approximately elliptical, or approximately square.

The wire diameter of the silver wires 18 can be, for example, 5 µm or more and 50 µm or less. The wire diameter of the silver wires 18 is the diameter of the smallest circle on a cross section perpendicular to the length direction of the silver wires 18. When the silver wires 18 have a coating layer on the side surface, the diameter of the silver wires 18 also includes the thickness of the coating layer.

The shape of the cross section and the wire diameter of the plurality of silver wires 18 included in the anisotropically conductive connector 1 may be the same or different.

The end of the silver wires 18 on the first surface 16a side of the insulation portion 16 may protrude from the first surface 16a of the insulation portion 16. Similarly, the end of the silver wires 18 on the second surface 16b side of the insulation portion 16 may protrude from the second surface 16b of the insulation portion 16. The length of the portion of the silver wires 18 that protrudes from the first surface 16a or the second surface 16b of the insulation portion 16 can be, for example, 1 µm or more and 60 µm or less.

The adhesive forming the adhesion portion 14 is not particularly limited, and examples thereof include known hardening adhesives. The number of adhesives forming the adhesive portion 14 may be one or more types.

The length and thickness of the adhesive portion 14 may be set within a range that allows sufficient adhesion of adjacent conductive band portions 12, and may be set to be the same as the length and thickness of the insulation portion 16, for example. The width of the adhesive portion 14 is not particularly limited, and can be, for example, 0.01 mm or more and 0.05 mm or less. The thickness, length, and width of the adhesion portion 14 are values measured at 10 arbitrarily selected locations.

Although the anisotropically conductive connector 1 has a rectangular shape in plan view in the present embodiment, it is not limited to a rectangle, and may be a circle, an ellipse, a polygon, or the like. The dimensions of the anisotropically conductive connector 1 may be set as appropriate depending on the application, and may be a rectangle with a length of 5 mm or more and 50 mm or less, and a width of 5 mm or more and 100 mm or less.

The arrangement pattern of the silver wires 18 when the anisotropically conductive connector 1 is viewed from the thickness direction (Z direction) is not particularly limited. The arrangement pattern of the silver wires 18 may be a two-dimensional array pattern in which the plurality of silver wires 18 are arranged in line in the length direction (X direction) of each strip-shaped insulation portion 16 are also arranged linearly in the width direction (Y direction) of the insulation portion 16. In this case, the pitch of the silver wires 18 arranged in the width direction (Y direction) of the insulation portion 16 can be made the same as the pitch of the silver wires 18 arranged in the length direction (X direction) of the strip-shaped insulation portion 16, for example. Further, the arrangement pattern of the silver wires 18 may be staggered.

The wiring density of the silver wires 18 in the conductive portion 10 when the anisotropically conductive connector 1 is viewed from the thickness direction can be set as appropriate depending on the application, and is, for example, 10 wires/mm² or more and 1,100 wires/mm² or less. The wiring density of the silver wires 18 can be adjusted by adjusting the pitch of the silver wires 18 in the length direction of the insulation portion 16, the width of the insulation portion 16, the width of the adhesion portion 14, and the like.

### [Manufacturing method of anisotropically conductive connector]

Hereinafter, a method for manufacturing the anisotropically conductive connector 1 will be described.

The method for manufacturing the anisotropically conductive connector 1 is not particularly limited, and any known method can be used as long as the silver wires are used as the conductive wires. The method for manufacturing the anisotropically conductive connector 1 of the present embodiment includes, for example, a core sheet forming process, a laminating process, and a cutting process, which will be described later.

### (Core sheet forming process)

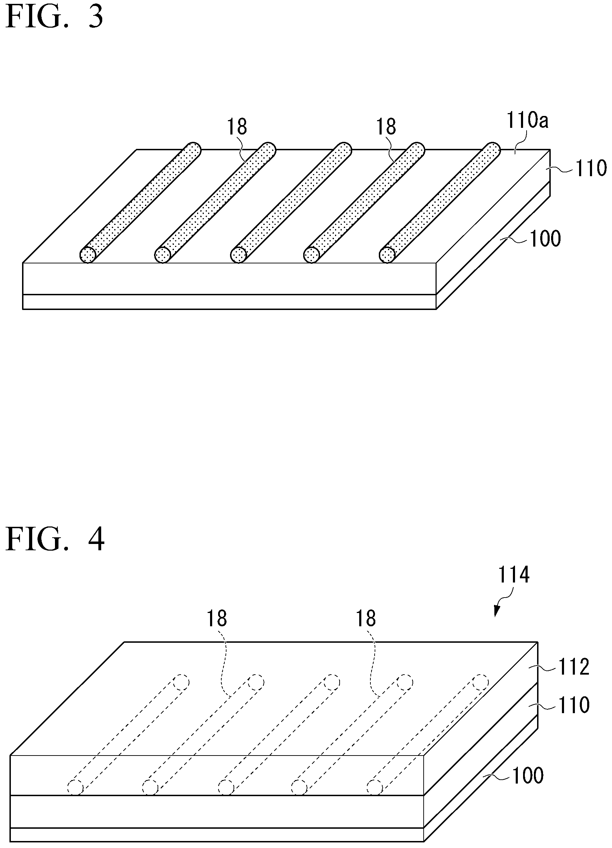

As shown in FIG. 3, a first insulating layer 110 is formed on the surface of a base material 100 using an insulating elastic material to form the insulation portion 16, and the plurality of silver wires 18 are arranged in parallel at regular intervals on an upper surface 110a of the first insulating layer 110. The base material 100 is not particularly limited as long as the first insulating layer 110 can be formed on the surface thereof, and examples thereof include flat members such as resin sheets, metal plates, and glass plates.

As shown in FIG. 4, a second insulating layer 112 is formed on the surface of the first insulating layer 110 to cover the silver wires 18 using an elastic material having insulating properties to form the insulation portion 16, and a core sheet 114 is formed on the surface of the first insulating layer 110.

### (Laminating process)

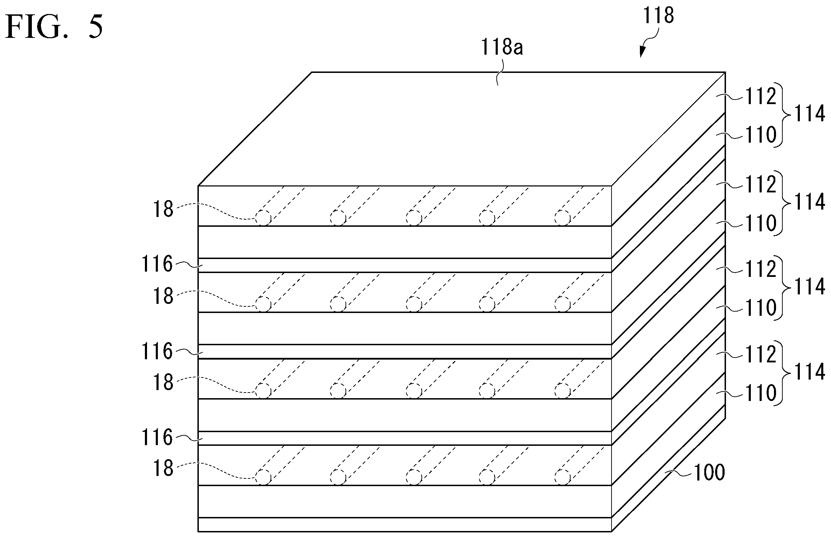

A plurality of core sheets 114 are produced in the same manner, and unnecessary base material 100 is removed to obtain a sheet laminate 118 in which a plurality of core sheets 114 are laminated with an adhesive layer 116 in between, as shown in FIG. 5. The adhesive used for the adhesive layer 116 is the adhesive that forms the adhesion portion 14. In the sheet laminate 18, the length directions of the silver wires 18 included in each core sheet 114 are aligned.

### (Cutting process)

The sheet laminate 118 is cut by inserting a blade from the upper surface 118a side of the sheet laminate 118 in a direction oblique to the length direction of each silver wire 18, and a sheet-shaped anisotropically conductive connector 1 having a desired thickness is obtained.

As described above, in the anisotropically conductive connector of the present invention, the flexible silver wires 18 are provided at an angle with respect to the thickness direction of the insulation portion. Therefore, even when electric and electronic components are repeatedly compressed during inspection, or even when mounted electric and electronic components repeatedly expand and contract due to changes in environmental conditions such as temperature and humidity, abrasion marks are less likely to occur on the electrodes that come into contact with the silver wire, and the accumulation of oxidized foreign matter is reduced. Therefore, an increase in resistance value over time can be suppressed.

Furthermore, the thickness of the anisotropically conductive connector using silver wires of the present invention can be easily changed depending on the coplanarity of the electrodes to be connected.

Additionally, hen silver wires are used, the silver wires can be arranged at narrow pitches depending on impedance simulation results for high-frequency applications, and the like. Furthermore, in the case of electronic devices and module components that use high-frequency characteristics, by reducing the thickness of the anisotropically conductive connector, the conductive path becomes as thin as a solder mounted, making it possible to carry out the inspection under the same conditions as when electronic device or module components are mounted.

Note that the anisotropically conductive connector of the present invention is not limited to the anisotropically conductive connector 1 described above.

For example, the configuration is not limited to a configuration in which a plurality of silver wires are provided at an angle with respect to the second surface of the insulation portion, and the plurality of silver wires may be provided perpendicularly to the second surface of the insulation portion.

When the silver wires are arranged perpendicular to the second surface of the insulation portion, repeated compression characteristics (durability) are inferior to those provided at an angle, but the shortest conductive path can be formed using a thin film. For this reason, there is a tendency that attenuation of high-frequency characteristics can be significantly suppressed compared to a probe pin with a long conduction path.

Furthermore, when used in mounting high-frequency devices such as LGA (Land Grid Array), module parts, and the like, it is easier to replace the devices when they are defective compared to ACF (anisotropic conductive film) and solder mounting.

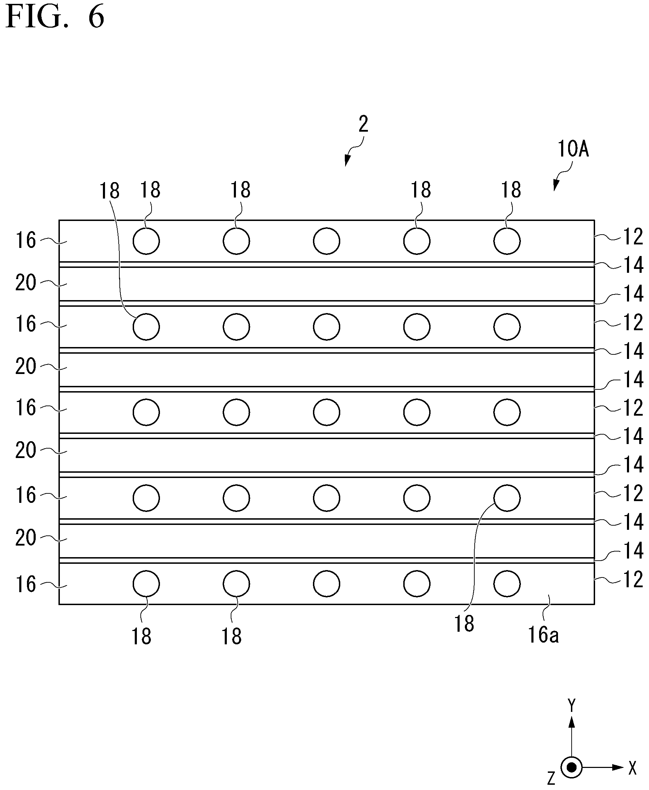

Further, the anisotropically conductive connector of the present invention may include a conductive portion further including an insulation portion in which no silver wires are provided. Specifically, it may be the anisotropically conductive connector 2 illustrated in FIG. 6, for example. The same parts in FIG. 6 as in FIG. 1 are given the same reference numerals, and the explanation will be omitted.

The anisotropically conductive connector 2 includes a conductive portion 10A in which the conductive band portion 12 in which the plurality of silver wires 18 are provided in a strip-shaped insulation portion 16 and a strip-shaped insulation portion 20 in which the silver wires 18 are not provided are alternately arranged in the width direction (Y direction), and are bonded together by the adhesion portion14. In this way, the conductive portion may include a conductive band portion in which the plurality of silver wires is provided, and an insulation portion in which no silver wires are provided.

The thickness and length of the insulation portion 20 may be suitably set depending on the application, and can be made the same as the thickness and length of the insulation portion 16, for example. The width of the insulation portion 20 may be suitably set depending on the wiring density of the silver wires 18, and may be, for example, 0.1 mm or more and 0.5 mm or less. The material constituting the insulation portion 20 can be exemplified by an elastic material having the same insulation properties as the material constituting the insulation portion 16, and the preferred materials are also the same.

The compression set of the insulation portion 20 is preferably 20% or less, and more preferably 18% or less, for the same reason as the compression set of the insulation portion 16.

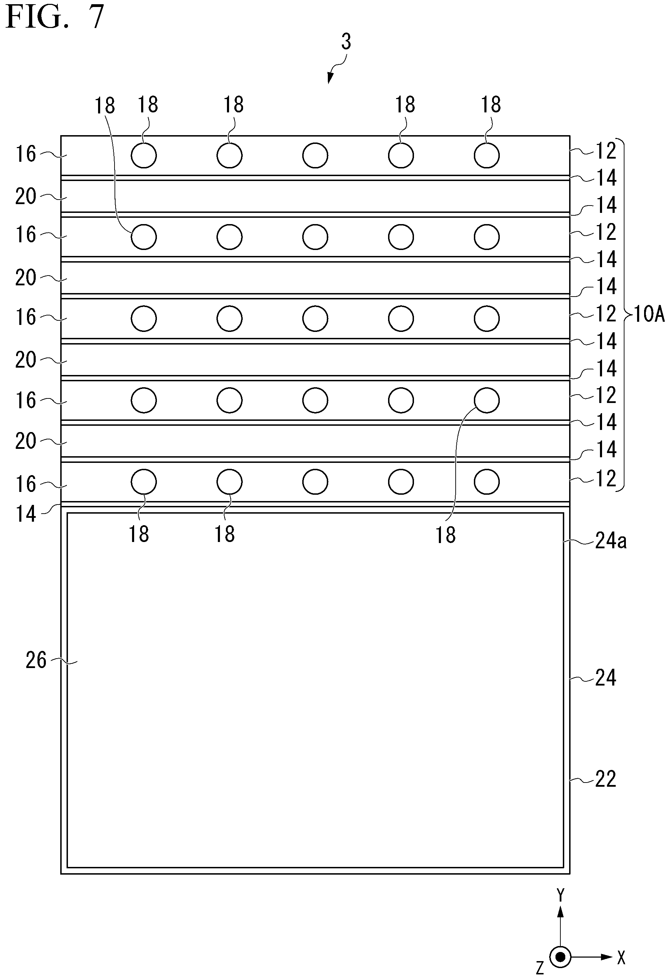

The anisotropically conductive connector of the present invention may be, for example, an anisotropically conductive connector 3 illustrated in FIG.7. The same parts in FIG. 7 as in FIGS. 1 and 6 are given the same reference numerals, and the description thereof will be omitted.

The anisotropically conductive connector 3 has the same configuration as that of the anisotropically conductive 2, except that the anisotropically conductive connector 3 further includes an attaching portion 22 adhered by an adhesion portion 14 adjacent to the insulation portion 16 in the width direction (Y direction) in the conductive portion 10A.

The attaching portion 22 includes an insulation portion 24 having a rectangular shape in plan view, and an adhesive layer 26 provided on a first surface 24a side of the insulation portion 24 in the thickness direction.

Since the anisotropically conductive connector 3 includes the attaching portion 22, the anisotropically conductive connector 3 can be directly attached by the adhesion layer 26 to the surface at which the electrode terminals of the circuit board in the inspection apparatus are provided or the surface at which the electrode terminals of the circuit board in electric and electronic parts such as electronic device parts and module parts are provided. Furthermore, since the anisotropically conductive connector 3 can be attached to a circuit board and handled as one, electric and electronic components and inspection apparatuses which include the anisotropically conductive connector 3 can be easily used in automatic manufacturing using machines.

In recent years, electronic device parts and module parts have become more compact as electronic equipment have been reduced in size. Additionally, dummy electrodes (hold-downs) have been used to increase mounting strength. Therefore, the number of electrodes is increased, and positioning of the electrodes is difficult. Furthermore, in electric and electronic components, inspection apparatuses, and the like that require multiple electrodes, repair work is extremely difficult if they are defective. However, if the anisotropically conductive connector 3 is attached by the adhesive layer 26, positioning is easier than by soldering, and replacement during repair work is also easier.

The shape and dimensions of the insulation portion 24 may be set as appropriate, and may be, for example, rectangular with a length of 2 mm or more and 50 mm or less and a width of 5 mm or more and 100 mm or less.

The material constituting the insulation portion 24 can be exemplified by an elastic material having the same insulation properties as the material constituting the insulation portion 16, and the preferred embodiments are also the same.

The adhesive forming the adhesive layer 26 is not particularly limited, and examples thereof include known curable adhesives. The number of adhesives forming the adhesive layer 26 may be one or more types.

The thickness of the adhesive layer 26 may be set within a range that allows the anisotropically conductive connector 3 to be stably attached to a substrate, and may be, for example, 0.01 mm or more and 0.04 mm or less. The thickness of the adhesive layer 26 is the average value of values measured at 10 arbitrarily selected locations.

### [Anisotropically conductive connector having a frame]

A frame for positioning may be provided around the anisotropically conductive connector of the present invention.

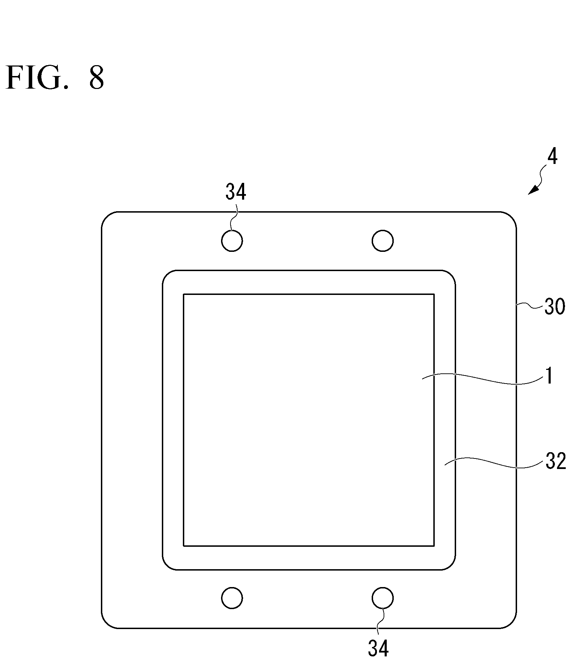

FIG. 8 shows a schematic configuration of an embodiment of an anisotropically conductive connector having a frame.

In an anisotropically conductive connector 4 having a frame, an annular frame 30 is provided around the entire circumference of the anisotropically conductive connector 1.

The frame 30 is punched out in a rectangular central region, and the anisotropically conductive connector 1 is adhered to this region by an adhesive 32. The top surface of the anisotropically conductive connector 1 and the top surface of the frame 30 are substantially parallel to each other.

The frame 30 is provided with a plurality of through holes 34. When mounting the anisotropically conductive connector 4 having a frame on a board or the like, the anisotropically conductive connector 4 having a frame can be easily mounted on a board or the like by, for example, by passing a positioning pin through the through hole 34 of the frame 30 and fixing it.

The shape of the frame 30 in plan view is rectangular in the embodiment shown in FIG. 8, but is not limited thereto. The frame 30 does not need to surround the entire circumference of the anisotropically conductive connector 1, and may be partially attached at one or more locations around the anisotropically conductive connector 1. The size of the frame 30 may be suitably designed depending on the object on which the anisotropically conductive connector 1 is mounted.

The material of the frame 30 is not particularly limited, and may be, for example, a resin frame, a metal frame, or the like.

The adhesive 32 is a cured adhesive, and is selected from a material having heat resistance and cold resistance to maintain a stable cured state in the operating temperature range of the anisotropically conductive connector 1. Specifically, examples of the adhesive 32 include acrylic resin, silicone, acrylic-modified silicone, and cyanoacrylate resin.

The adhesion surface of the adhesive material 32 on the frame 30 may be subjected to a primer treatment in advance to increase adhesion.

The method for manufacturing the anisotropically conductive connector having a frame is not particularly limited, and any known method can be used as long as the anisotropically conductive connector of the present invention is used.

Note that the anisotropically conductive connector having a frame of the present invention is not limited to the above-mentioned anisotropically conductive connector 4 having a frame as long as it is equipped with the anisotropically conductive connector of the present invention, the design of the anisotropically conductive connector having a frame of the present invention can be changed as appropriate depending on the inspection apparatus, electric and electronic components, and the like to which it is applied.

### [Inspection apparatus]

The anisotropically conductive connector of the present invention can be used in an inspection apparatus for inspecting electric and electronic components such as electronic device parts and module parts.

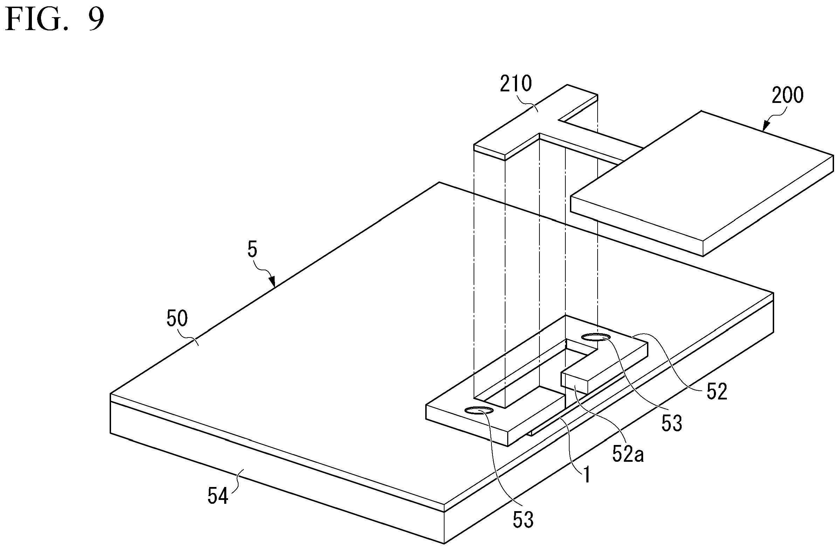

FIG. 9 is a perspective view showing an example of an inspection apparatus 5 including an anisotropically conductive connector of the present invention.

The inspection apparatus 5 shown in FIG. 9 includes a circuit board 50 provided with electrode terminals, the anisotropically conductive connector 1, a holder 52, and a plate 54.

The circuit board 50 may be any circuit board provided with electrode terminals, such as a printed wiring board. In the present embodiment, the circuit board 50 is placed on the plate 54, but the embodiment is not limited to this arrangement.

The material of the plate 54 is not particularly limited, and may be made of resin or metal.

The holder 52 is a member for fixing the outer peripheral portion of the anisotropically conductive connector 1 onto the circuit board 50. The holder 52 in the present embodiment has a C-shape with a partially chipped portion 52a on one side of a rectangular frame. Note that the shape of the holder 52 is not limited to the shape of the present embodiment, and may be, for example, a frame shape without a chipped portion.

The material of the holder 52 is not particularly limited, and may be made of resin or metal.

In the inspection apparatus 5, the anisotropically conductive connector 1 is placed on the circuit board 50, the holder 52 is placed on top of the anisotropically conductive connector 1, and the bolt 53 is screwed into the bolt hole of the holder 52. Thereby, the outer peripheral portion of the anisotropically conductive connector 1 is held between the circuit board 50 and the holder 52, so that the anisotropically conductive connector 1 is fixed on the circuit board 50. In this state, the electrode terminal provided on the circuit board 50 is in contact with the end of the silver wires 18 of the anisotropically conductive connector 1 on the circuit board 50 side.

For example, when inspecting an electric and electronic component 200 having a flexible printed wiring board 210 as a circuit board to be inspected, the flexible printed wiring board 210 is fitted and pressed to a T-shaped area of the anisotropically conductive connector 1 to the side in contact with the circuit board 50 and not in contact with the holder 52. Then, the electrode provided on the flexible printed wiring board 210 of the electric and electronic component 200 is brought into contact with the end of the silver wires 18 of the anisotropically conductive connector 1 of the inspection apparatus 5 on the side opposite to the side in contact with the circuit board 50.

Thereby, the electrode terminals of the circuit board 50 in the inspection apparatus 5 and the electrodes of the flexible printed wiring board 210 to be inspected are electrically connected through the silver wires 18 of the anisotropically conductive connector 1, and inspection can be performed.

The method for manufacturing the inspection apparatus 5 is not particularly limited, and any known method can be used as long as the anisotropically conductive connector of the present invention is used.

Note that the inspection apparatus of the present invention is not limited to the above-described inspection apparatus 5 as long as it includes the anisotropically conductive connector of the present invention, and the design can be changed as appropriate depending on the electronic device parts, module parts, and the like to which it is applied.

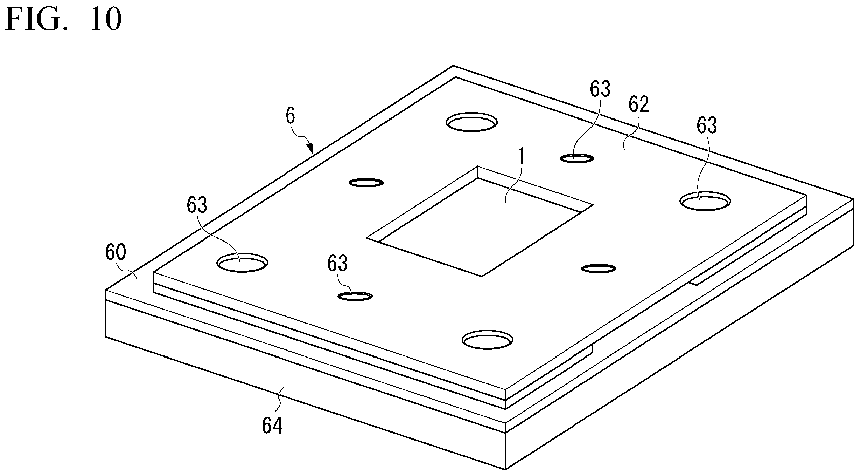

For example, the inspection apparatus (socket) 6 illustrated in FIG. 10 may be used. The inspection apparatus 6 includes a circuit board 60 provided with electrode terminals, the anisotropically conductive connector 1, a holder 62, and a plate 64.

The circuit board 60 may be any circuit board provided with electrode terminals, such as a printed wiring board. In the present embodiment, the circuit board 60 is placed on the plate 64, but is not limited to this arrangement.

The material of the plate 64 is not particularly limited, and may be made of resin or metal.

The holder 62 is a member for fixing the outer peripheral portion of the anisotropically conductive connector 1 onto the circuit board 50, and has a rectangular frame shape.

The material of the holder 62 is not particularly limited, and may be made of resin or metal.

In the inspection apparatus 6, the anisotropically conductive connector 1 is placed on the circuit board 60, the holder 62 is placed on top of the anisotropically conductive connector 1, and a bolt 63 is screwed into the bolt hole of the holder 62. Thereby, the outer peripheral portion of the anisotropically conductive connector 1 is held between the circuit board 60 and the holder 62, so that the anisotropically conductive connector 1 is fixed on the circuit board 60. In this state, the electrode terminal provided on the circuit board 60 is in contact with the end of the silver wires 18 in the anisotropically conductive connector 1 on the circuit board 60 side.

During inspection, a semiconductor device such as a BGA, QFN, SOP, QFP, or CSP is fitted in the frame of the holder 62 and pressed against the anisotropically conductive connector 1 opposite to the side in contact with the circuit board 60. Then, the electrode of the semiconductor device is brought into contact with the end of the silver wires 18 of the anisotropically conductive connector 1 of the inspection apparatus 6 on the side opposite to the side in contact with the circuit board 60.

Thereby, the electrode terminals of the circuit board 60 in the inspection apparatus 6 and the electrodes of the semiconductor device are electrically connected through the silver wires 18 of the anisotropically conductive connector 1, and inspection can be performed.

The method for manufacturing the inspection apparatus 6 is not particularly limited, and any known method can be used as long as the anisotropically conductive connector of the present invention is used.

The inspection apparatus of the present invention may include an anisotropically conductive connector having a frame.

More specifically, the inspection apparatus of the present invention may be an inspection apparatus in which the anisotropically conductive connector having a frame is fixed to a circuit board using positioning pins, holders, and the like, and the circuit of the electric and electronic component to be inspected is pressed to the anisotropically conductive connector having a frame opposite to the side in contact with the circuit board.

Hereinafter, the present invention will be explained in detail with reference to Examples, but the present invention is not limited by the following description.

### [Initial contactability evaluation test]

Using the test equipment below, an anisotropically conductive connector was placed on a gold-plated solid electrode, and the load value and resistance value were measured when the anisotropically conductive connector was compressed by a gold-plated pin electrode attached to the tip of a load cell.

### (Test equipment)

Testing machine: Automatic load testing machine (MAX-1KN-M, manufactured by Japan Keisoku System Co., Ltd.)
Load cell: JLC-M50N (50N)
Measuring electrode: Φ 0.14 mm gold-plated pin electrode, gold-plated solid electrode
Resistance meter: RM3545-02 (manufactured by Hioki Electric)
Measurement conditions: Compression amount control (50% of the thickness of the anisotropically conductive connector)
Test speed: 1 mm/min

### [Experiment Example 1]

A coating film (first insulating layer) with a thickness of 0.025 mm made of uncured silicone rubber (manufactured by Shin-Etsu Chemical Co., Ltd.) was formed on a polyester film (base material), and gold-plated beryllium copper wires (wire diameter: 23 µm, elongation at break: 1.29%, maximum point load: 0.58 N, and 0.2% proof load: 0.35 N) were arranged in parallel to each other at intervals of about 0.05 mm on the coating film (first insulating layer). Then, a coating film (second insulating layer) with a thickness of 0.025 mm was formed using silicone rubber to cover the conductive wires, and was cured by heating to obtain a core sheet. A plurality of core sheets were prepared in the same manner and were laminated with an adhesive so that the length directions of the conductive wires were aligned in parallel to obtain a sheet laminate.

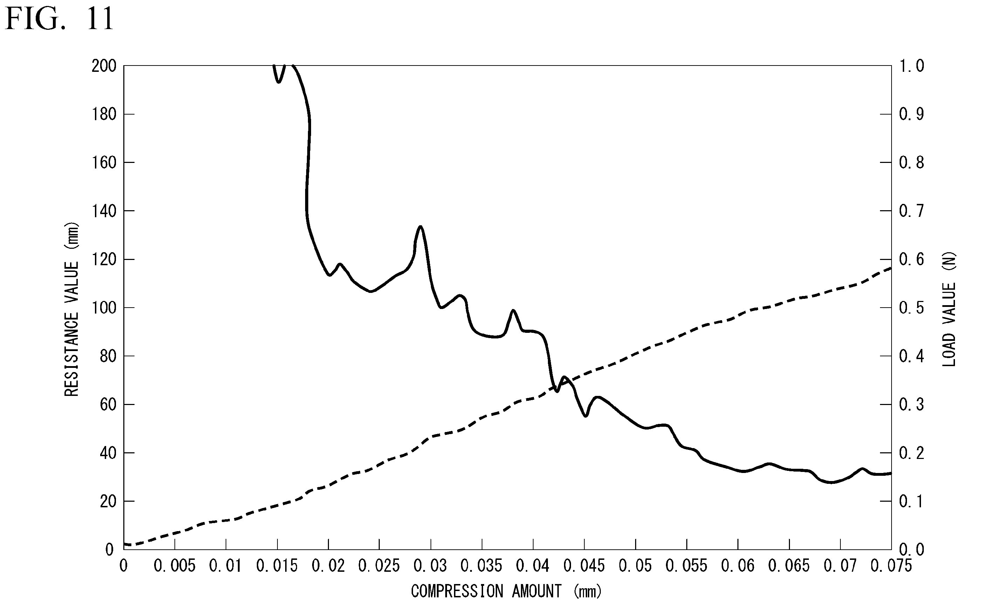

By slicing the sheet laminate, an anisotropically conductive connector was obtained of which the pitch of the conductive wires in the length direction (X direction) and width direction (Y direction) of the insulation portion was 0.05 mm, the inclination angle θ of the conductive wires was 63.4 degrees, and the thickness was 0.15 mm. An initial contactability evaluation test was carried out using the obtained anisotropically conductive connector. The results are shown in FIG. 11.

### [Experiment Example 2]

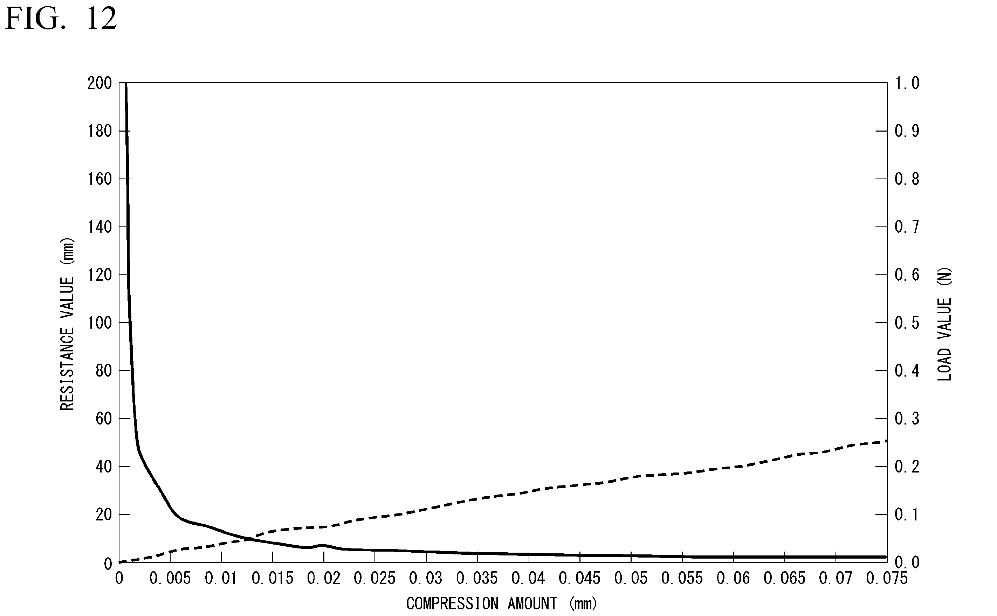

An anisotropically conductive connector was manufactured in the same manner as in Experiment Example 1, except that gold-plated silver wires (wire diameter: 25 µm, elongation at break: 1.17%, maximum point load: 0.17N, and 0.2% proof load: 0.15 N) were used as the conductive wires, and an initial contactability evaluation test was carried out. The results are shown in FIG. 12.

As shown in FIGS. 11 and 12, the anisotropically conductive connector of Experimental Example 2 using silver wires has a lower resistance than the anisotropically conductive connector of Experimental Example 1 using brass wires even with a small compression amount of about 0.005 mm. As explained above, the anisotropically conductive connector using the silver wires in Experimental Example 2 was able to connect the silver wires to the electrode with low resistance and low load.

### [Evaluation test of repeated compression characteristics (durability)]

Using the test equipment below, an evaluation jig consisting of a backup plate was installed in the load testing machine, and an evaluation board, an anisotropically conductive connector, and a PKG guide (however, "PKG" means a package) were sequentially placed on the evaluation jig. A gold-plated pin electrode with a commercially available dummy PKG attached to the tip was installed at the tip of the load cell, and the dummy PKG was repeatedly pressed against the anisotropically conductive connector so that the load value was 20 N each time, and the resistance value was measured.

### (Test equipment)

| | |
|---|---|
| Testing machine: | Automatic load testing machine (MAX-1KN-M, manufactured by Japan Keisoku System Co., Ltd.) |
| Load cell: | JLC-M50N (50N) |
| Dummy PKG: | WLP64T. 3C-DC088D (pitch: 0.3mm, solder ball: Φ0.2mm) |
| Measurement electrode: | Φ 1mm gold-plated pin electrode, evaluation board for WLP64 (daisy chain connection) |
| Resistance meter: | RM3545-02 (manufactured by Hioki Electric) |
| Measurement conditions: | Load control (20N) |
| Test speed: | 6 mm/min |
| Measurement interval: | Every 25 times (1 second stop during measurement) |
| Dummy PKG replacement frequency: | Every 5,000 times (repetitive compression characteristics only) |

### [Experiment Example 3]

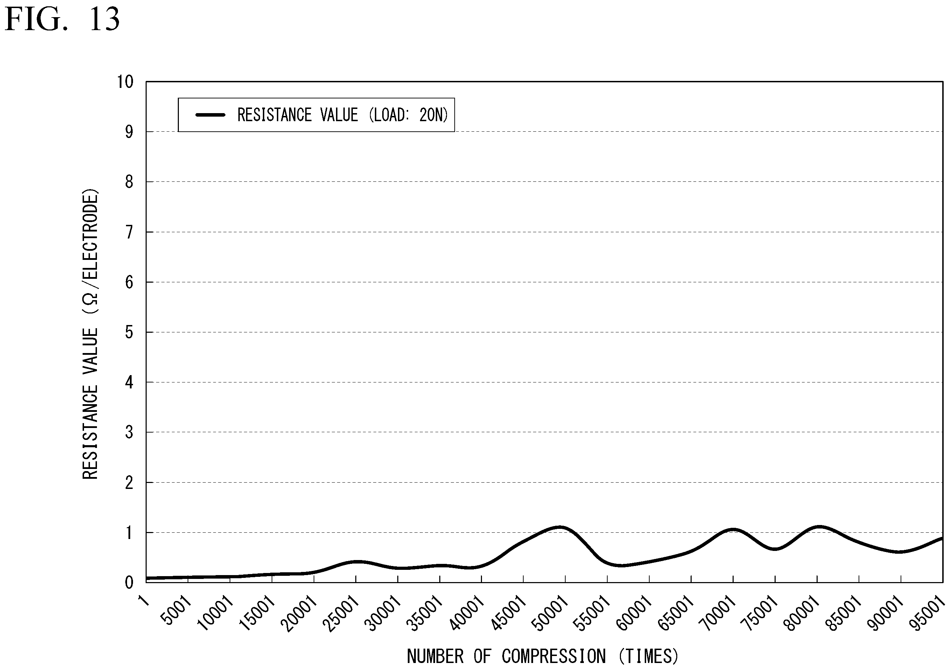

An anisotropically conductive connector was manufactured in the same manner as in Experiment Example 1, except that gold-plated beryllium wires (wire diameter: 23 µm, elongation at break: 1.29%, maximum point load: 0.58N, and 0.2% proof load: 0.35 N) were used as the conductive wires, and repeated evaluation tests for compression characteristics (durability) were carried out. The results are shown in FIG. 13.

### [Experiment Example 4]

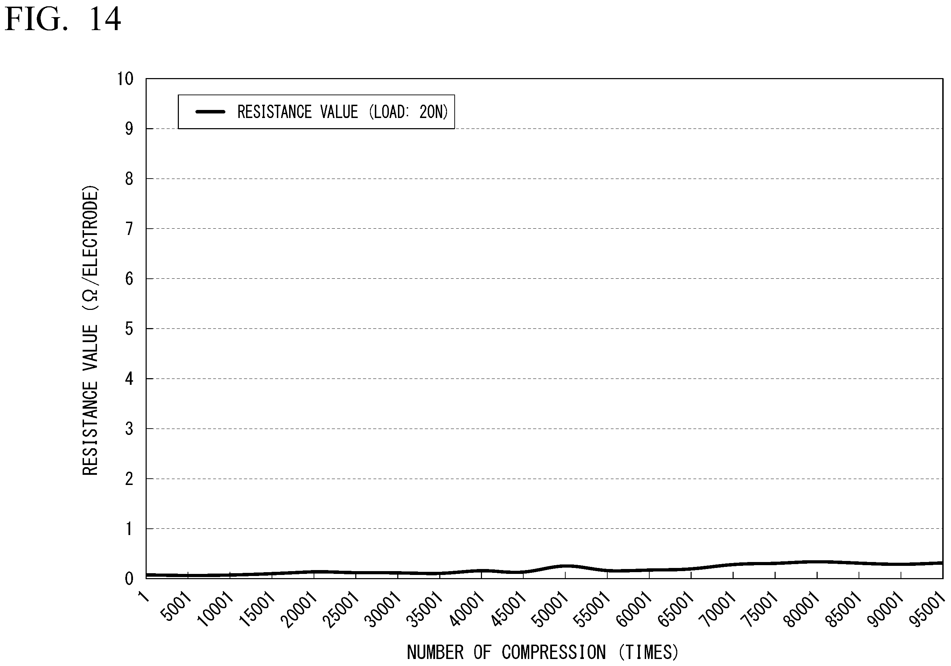

An anisotropically conductive connector was manufactured in the same manner as in Experiment Example 1, except that gold-plated silver wires (wire diameter: 25 µm, elongation at break: 1.17%, maximum point load: 0.17N, and 0.2% proof load: 0.15 N) were used as the conductive wires, and repeated evaluation tests for compression characteristics (durability) were carried out. The results are shown in FIG. 14.

Note that FIGS. 13 and 14 summarize the data at the first compression immediately after the dummy PKG exchange every 5000 compressions.

As shown in FIGS. 13 and 14, it was found that the resistance value hardly increased until the number of compressions was about 45,000 and the increase in resistance value during continuous use could be sufficiently suppressed in the anisotropically conductive connector of Experimental Example 4 using silver wires compared to the anisotropically conductive connector using beryllium copper wires in Experimental Example 3.

### [Experiment example 5]

An anisotropically conductive connector was manufactured in the same manner as in Experiment Example 1, except that gold-plated silver wires (wire diameter: 25 µm, elongation at break: 1.17%, maximum point load: 0.17 N, 0.2% proof load: 0.15 N, and gold plated directly on the silver wire) were used, and the inclination angle was 90 degrees, that is, the silver wires were arranged perpendicular to the second surface, and the initial contactability was evaluated.

As a result, the initial contactability and repeated compression characteristics (durability) were slightly inferior to the evaluation test results shown in FIGS. 12 and 14 because buckling of the conductive wires occurred.

### EXPLANATION OF REFERENCE NUMERALS

- 1 to 3: anisotropically conductive connector
- 4: anisotropically conductive connector having a frame
- 5, 6: inspection apparatus
- 10, 10A: conductive portion
- 12: conductive band part
- 14: adhesion portion
- 16: insulation portion
- 18: silver wire
- 20: insulation portion
- 22: attaching portion
- 24: insulation portion
- 26: adhesive layer
- 30: frame
- 32: adhesive material
- 34: through hole
- 50, 60: circuit board
- 52, 62: holder
- 54, 64: plate

## Claims

1. An anisotropically conductive connector, comprising an insulation portion which is strip-shaped and made of an elastic material having insulating properties, and
a plurality of silver wires which penetrate the insulation portion from a first surface to a second surface in a thickness direction and are arranged at a constant pitch in a length direction of the insulation portion, wherein each of the plurality of silver wires is provided perpendicularly or obliquely to the second surface of the insulation portion.

2. The anisotropically conductive connector according to Claim 1, wherein a tensile strength of the silver wires measured according to JIS Z 2241 is 200 N/mm² or more and 380 N/mm² or less.

3. The anisotropically conductive connector according to Claim 1, wherein a gold plating film is formed on the side surface of the silver wires.

4. The anisotropically conductive connector according to Claim 1, wherein a compression set of the insulation portion is 20% or less.

5. An anisotropically conductive connector having a frame, wherein a positioning frame is fixed to at least a part of the periphery of the anisotropically conductive connector according to any one of Claims 1 to 4.

6. An inspection apparatus for an electric and electronic component, comprising a circuit board having an electrode terminal, the anisotropically conductive connector according to any one of Claims 1 to 4, and a holder,
wherein at least a part of a peripheral portion of the anisotropically conductive connector is fixed onto the circuit board by the holder,
wherein the electrode terminal is in contact with one end of the silver wires of the anisotropically conductive connector on the side in contact with the circuit board,
wherein during inspection, the electric and electronic component is fitted and pressed to a region of the anisotropically conductive connector opposite to the side in contact with the circuit board, and not in contact with the holder, and an electrode of the electric and electronic component is in contact with the other end of the silver wires of the anisotropically conductive connector on an opposite side to the side in contact with the circuit board.

7. An inspection apparatus for an electric and electronic component, comprising a circuit board having an electrode terminal, the anisotropically conductive connector having a frame according to Claim 5, and a holder,
wherein at least a part of the frame of the anisotropically conductive connector having a frame is fixed onto the circuit board by the holder,
wherein the electrode terminal is in contact with one end of the silver wires of the anisotropically conductive connector having a frame on the side in contact with circuit board,
wherein during inspection, the electric and electronic component is fitted and pressed to a region of the anisotropically conductive connector having a frame opposite to the side in contact with the circuit board, and not in contact with the holder, and an electrode of the electric and electronic component is in contact with the other end of the silver wires of the anisotropically conductive connector having a frame on an opposite side to the side in contact with the circuit board.
